Europäisches Patentamt

European Patent Office

Office européen des brevets

(11) Publication number: **0 088 548**
**B1**

(12) **EUROPEAN PATENT SPECIFICATION**

(45) Date of publication of patent specification: **08.06.88**

(21) Application number: **83300872.5**

(22) Date of filing: **18.02.83**

(51) Int. Cl.⁴: **H 03 H 9/17, H 03 H 3/04**

(54) Piezoelectric resonators.

(30) Priority: 22.02.82 JP 25993/82
20.04.82 JP 65945/82
28.04.82 JP 72450/82
07.07.82 JP 117999/82

(43) Date of publication of application:
14.09.83 Bulletin 83/37

(45) Publication of the grant of the patent:
08.06.88 Bulletin 88/23

(84) Designated Contracting States:
DE FR GB

(56) References cited:
FR-A-2 235 532
US-A-3 525 885

PATENTS ABSTRACTS OF JAPAN, vol. 5, no.
149(E-75)(821), 19th September 1981; & JP - A -
56 83110 (TOKYO SHIBAURA DENKI K.K.)
07-07-1981

(73) Proprietor: FUJITSU LIMITED
1015, Kamikodanaka Nakahara-ku
Kawasaki-shi Kanagawa 211 (JP)

(72) Inventor: Fujiwara, Yoshiro
1-718, Kosugigoten-cho Nakahara-ku
Kawasaki-shi Kanagawa 211 (JP)
Inventor: Yamada, Sumio
Fujitsu Meiwa-ryo, 30 Shimokodanaka
Nakahara-ku, Kawasaki-shi Kanagawa 211 (JP)
Inventor: Hoshino, Hiroshi
Ryowa-so, 2233, Minamikase Saiwai-ku
Kawasaki-shi Kanagawa 211 (JP)
Inventor: Wakatsuki, Noboru
Nakanoshima-jutaku 3-402 1540-1,
Nakanoshima
Tama-ku Kawasaki-shi Kanagawa 214 (JP)

(74) Representative: Fane, Christopher Robin King
et al
HASELTINE LAKE & CO. Hazlitt House 28
Southampton Buildings Chancery Lane
London, WC2A 1AT (GB)

Courier Press, Leamington Spa, England.

(56) References cited:

**PROCEEDINGS OF THE 25TH ANNUAL FREQUENCY CONTROL SYMPOSIUM, U.S. Army Electronics Command, Electronic Industries Association, Fort Monmouth, N.J., 26th-27th-28th April 1971, pages 246-250, Washington, US; K.SAWAMOTO: "Energy trapping in a lithium tantalate X-cut resonator"**

**PATENTS ABSTRACTS OF JAPAN, vol. 3, no. 90(E-127), 31st July 1979, page 51 E 127; & JP - A - 54 68194 (FUJITSU K.K.) 01-06-1979**

**PROCEEDINGS OF THE IEE, vol. 123, no. 6, June 1976, pages 499-504, Herts, GB; J.W.BURGESS et al.: "Temperature coefficients of frequency in LiNbO3 and LiTaO3 plate resonators"**

## Description

The present invention relates to piezoelectric resonators, more particularly to a piezoelectric resonator comprising a substantially X-cut plate of lithium tantalate ($LiTaO_3$) crystal.

A piezoelectric resonator comprises a plate of piezo-electric material such as a crystal of lithium tantalate and an electrode film coated upon the upper and lower main surfaces of the plate. When an alternating (a.c.) electric field is applied between the electrode films, the piezo-electric plate is subject to stress at a frequency equal to that of the a.c. electric field. Such a vibrating stress mode is called thickness shear. When the frequency of the a.c. electric field coincides with the inherent resonance frequency of the piezoelectric plate, electric resonance occurs, resulting in greater oscillation.

Oscillating devices comprising such piezoelectric resonators are widely used in oscillators or filters of communication apparatus due to their compactness, high reliability, and high stability of oscillation frequency. Ideally, single-mode resonators in which spurious responses are eliminated are desired, and also multi-mode filters, wherein the oscillation energy is trapped or concentrated in the vicinity of the electrodes by the mass load effect and the piezoelectric reaction see for example the abstract of JP—A—56-83110 in Japanese Patent Abstracts, vol. 5, No. 149 (E-75) (821), 19th September 1981 and "Proceedings of the 25th Annual Frequency Control Symposium," 26th to 28th April 1971, pages 246 to 250).

In a prior $LiTaO_3$ piezoelectric resonator, however, spurious response was generated in the vicinity of the inherent frequency of the resonator, resulting in degradation of the resonator. The quality factor Q, which corresponds to the stability of frequency of oscillation, was also low in this known resonator. Further, with this known resonator, attempts to minimize fluctuations of frequency with changes of temperature, so as to obtain stable temperature characteristics, by selection of the cutting direction of the piezoelectric plate with respect to the crystal orientation, failed to achieve fully satisfactory results and in particular did not succeed in providing a single mode resonator in which spurious resonances are eliminated.

According to the present invention a piezoelectric resonator which resonates due to thickness shear comprises a strip shaped resonance chip, xade of an X-cut plate of lithium tantalate crystal and having a rectangular cross-section, and electrodes, formed at the centre portions with respect to the longitudinal direction of said resonance chip at the two X-plane surfaces thereof, the width of said electrodes being equal to the width of said resonance chip, the longitudinal direction of said resonance chip being inclined with respect to the Y-axis at an angle of $-50° \pm 2°$ (in the anticlockwise direction) in the X-plane so as to make said longitudinal direction of said resonance chip coincide with the displacement direction of the primary mode of the plate, said X-cut plate being rotated about the Y-axis and/or Z-axis within an angle range of 10°, the angles of rotation about the Y-axis and/or Z-axis being selected so that the trapped energy of the oscillation in said resonance chip is such that the primary temperature coefficient of said resonance chip is zero, and the ratio l/H being below 3.95, where l is the length of said electrodes and H is the thickness of hte resonance chip plate.

It will be understood that an X-cut plate is a crystal plate cut perpendicular to the X-axis of the crystal, and that the electrodes may be formed as films on the surface of the plate.

Reference will now be made, by way of example, to the accompanying drawings, in which:

Fig. 1 is a perspective view of a water of $LiTaO_3$ crystal;

Fig. 2 is a perspective view of a resonance chip cut from the wafer of Fig. 1;

Fig. 3 is an explanatory view showing the distribution of the oscillation energy of the resonance chip;

Fig. 4 is a perspective view of a resonator comprising the resonance chip of Fig. 2;

Fig. 5 is a graphic view of the frequency characteristic of a resonator of the prior art;

Fig. 6 is a graphic view of the frequency characteristic of a resonator of the present invention;

Fig. 7 is a graphic view of an equivalent series resistance $R_S$ and a quality factor Q of a resonator of $LiTaO_3$ with respect to a cutting angle $\phi$;

Fig. 8 is an explanatory view of a double-rotation-cut plate;

Fig. 9 is a graphic view of the relationship between the trapped energy and the rotational angle with respect to the Y-axis and Z-axis, in which the primary temperature coefficient is zero;

Fig. 10, is a graphic view of the temperature characteristic of the resonator of cutting direction $\theta=3°$ and $\phi=0°$, showing the shift of frequency when the trapped energy of the resonator is changed;

Fig. 11 is a graphic view of the relationship between the rotational angle $\theta$ and the trapped energy $\zeta$;

Fig. 12 is a graphic view of the temperature characteristic of the resonator of cutting direction $\theta=0°$ and $\phi=4°$, showing the shift of frequency when the trapped energy of the resonator is changed;

Fig. 13 is a graphic view of the relationship between the rotational angle $\phi$ and the trapped energy $\zeta$;

Fig. 14 is a graphic view of the relationship between the dimension ratio (L/H) of the resonator and the quality factor Q;

Fig. 15 is a view for explaining modes of oscillation of the resonance chip;

Fig. 16 is a graphic view of the frequency characteristic of the resonator of the prior art;

Fig. 17 is a graphic view of the admittance characteristic of the resonator;

Fig. 18 is a graphic view of a frequency constant

3

k in which spurious response is generated with respect to the dimension ratio (W/H) of the resonance chip;

Fig. 19 is a perspective view of part of a resonator including the resonance chip;

Fig. 20 is a perspective view of the resonance chip provided with terminal conductors;

Fig. 21 is a perspective view of the resonance chip provided with connecting conductors;

Fig. 22 is a graph showing the quality factor Q and equivalent series resistance $R_S$ with respect to the ratio (t/H), in which t is the thickness of a terminal member and H is the thickness of a chip plate;

Fig. 23 is a graph showing quality factor Q with respect to the ratio (w/L), in which w is the width of terminal member and L is the length of a chip plate;

Fig. 24 is a graph showing a frequency characteristic of a resonator having t/H=0.1; and

Fig. 25 is a graph showing a frequency characteristic of a resonator having t/H=0.36.

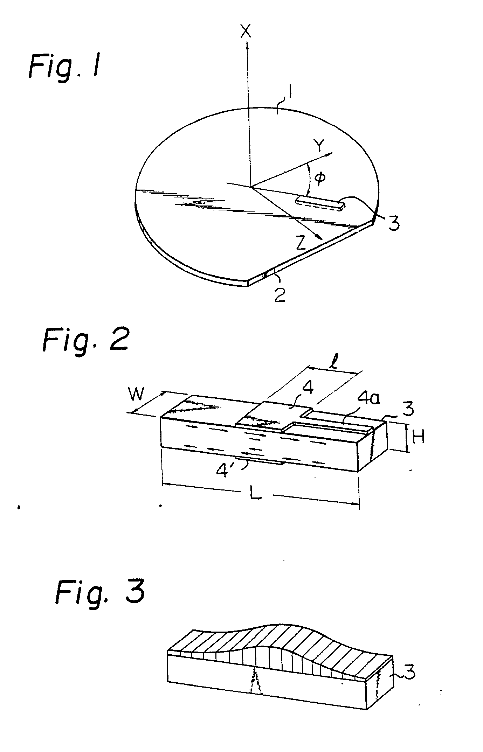

A wafer 1 illustrated in Fig. 1 is formed by cutting a crystal of lithium tantalate. The wafer 1 is an X-cut plate, i.e., a plate whose main surfaces are perpendicular to the X-axis of the crystal. The crystal of the X-cut plate may be rotated about the Y-axis and/or Z-axis. The wafer 1 has an edge 2 for positioning the wafer 1 at the time of cutting. The edge 2 is perpendicular to the Z-axis so that the wafer 1 can be easily positioned at a desired angle with respect to the crystal orientation. The Y-axis is parallel to the edge 2. A number of resonance chips 3 of a longitudinal box shape are cut from the wafer 1 in the same longitudinal direction.

A pair of electrodes 4, 4' (Fig. 2) are formed on the X planes, i.e., the planes perpendicular to the X-axis, of the bar-shaped resonance chip 3. The width of the electrode is equal to the width of the resonance chip. When high frequency voltage is applied to the pair of electrodes 4, 4', thickness shear mode is generated as shown by arrows in Fig. 2. The magnitude of such thickness shear mode is maximum at the center of the resonance chip 3 and minium at the ends, as shown in Fig. 3.

The upper electrode 4 is connected to a terminal (not shown) at an end of the resonance chip 3 through a lead 4a. The lower electrode 4' is connected to another terminal (not shown) at the other end of the resonance chip 3 through another lead.

Length L, width W, and thickness H of the rectangular-strip-shaped resonance chip 3 are determined as follows. Width W is made about 1.5 times larger than thickness H so that unnecessary responses generated within the resonance chip 3 do not affect the resonance of thickness shear mode. Width of the electrode 4 is made equal to the width W of the resonance chip 3 to equalize the energy of resonance in the transverse direction of the resonance chip 3 and prevent waves reflected from the sides of the resonance chip 3 from affecting the primary resonance oscillation. Since the width of the resonance chip 3 need only be the same as the width of the electrode 4, the resonator may be made narrow in width, and compact.

It is desirable that length L be more than 10 times larger than thickness H so that the energy of oscillation is efficiently concentrated and trapped between the pair of electrodes 4, 4' disposed at the center of the resonance chip 3. With such dimensions of the resonance chip 3, energy which is transmitted to the ends of the chip can be minimized so that waves reflected upon the end surfaces of the resonance chip 3 do not affect the main resonance. Also, with such dimensions, the resonance chip 3 can be held at the ends thereof since the acoustic energy is minimized there.

The thickness shear mode resonances in the X-cut plate comprises a fast mode and a slow mode. The displacememt directions of the fast and the slow shear waves are perpendicular to each other and constant with respect to the Y-axis of the crystal. The shear wave of the fast mode is used as the main resonance since the electro-mechanical coupling of the fast mode is very large. The orientation of the crystal of the resonance chip 3 is arranged so that the direction of the fast mode (shown by arrows in Fig. 2) coincides with the logitudinal direction of the chip 3. That is, the cutting direction of the resonance chip 3 in the wafer 1 is determined so that the angle φ (Fig. 1) between the Y-axis and the longitudinal direction of the chip 3 is equal to the constant angle between the Y-axis and the displacement direction of the thickness shear mode of the fast mode.

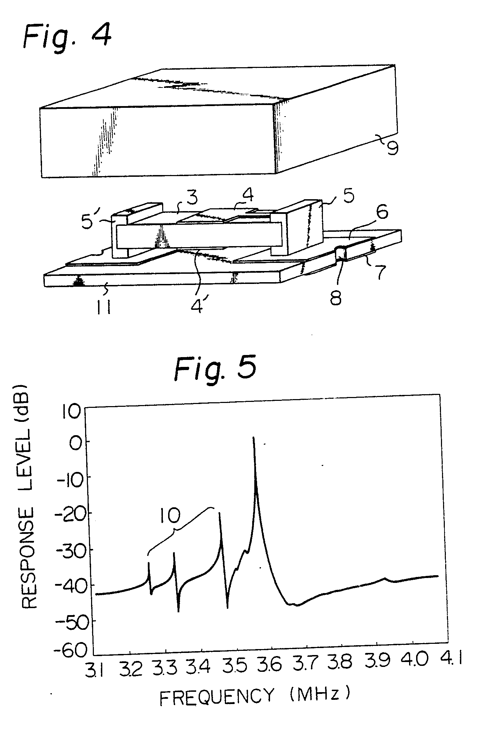

The angle between Y-axis and the displacement direction of the thickness shear mode of the piezoelectric resonator of the X-cut plate of lithium tantalate, i.e., angle φ in Fig. 1, has been previously proposed to be −53° (NDK technical report No. 6 '79, 11 "Oscillator Controlled by Electric Voltage Using Lithium Tantalate Resonator", Nippon Dempa Kogyo). However, the resonance chip of this angle generates spurious response 10 as can be seen in graph of frequency characteristic of Fig. 5.

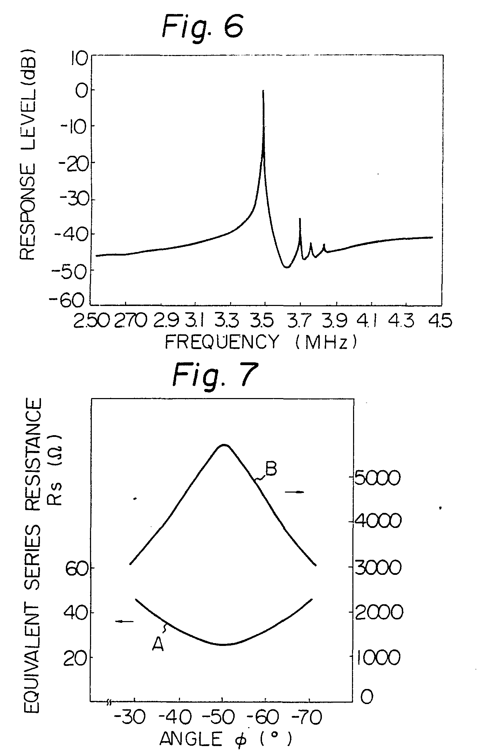

Figure 7 represents experimental data of the relationship of equivalent series resistance $R_S$ and quality factor Q with respect to the angle between the longitudinal direction of the resonance chip and the Y-axis of the X-cut plate of the crystal of lithium tantalate.

If the equivalent series resistance $R_S$ is large, the magnitude of displacement is small. The quality factor Q corresponds to the stability of the resonance frequency. Therefore, it is desirable that the quality factor Q be high and the equivalent series resistance be low.

In Fig. 7, the abscissa represents the angle φ, the left ordinate represents the equivalent series resistance $R_S$, and the right ordinate represents the quality factor Q. Graph A represents the relationship between the angle φ and the equivalent series resistance $R_S$. Graph B represents the relationship between the angle φ and the quality factor Q. As can be seen from graphs A and B, the equivalent series resistance $R_S$ is minimum when the angle φ=−50°. Also, the quality factor Q is maximum at that angle. Therefore, considering the allowance of $\pm 2°$, in an embodiment of the invention the angle $\phi$ is determined to be $-50°\pm2°$.

Figure 6 is a graphic view of admittance (frequency charateristic) as obtained from an experiment using a resonance chip 8 mm length, 0.5 mm thickness 1.35 mm width and having $\phi=-50°$. As can be seen from Fig. 6, the frequency characteristic of this resonance chip embodying the present invention comprises less spurious response than the characteristic of the proir chip represented in Fig. 5.

A resonance chip embodying chip embodying the present invention can be assembled as a chip resonator as shown in Fig. 4. The ends of the resonance chip 3 are held by electrode terminals 5 and 5', respectively. The electrode terminals 5 and 5' are connected to the electrodes 4 and 4', formed on the upper and lower surfaces of the center portion of the resonance chip 3, respectively. The electrode terminals 5 and 5' are connected to a thick film electrode 6 formed on the upper surface of a ceramic base 11. The thick film electrode 6 is connected to another thick film electrode 7 formed in the lower surface of the ceramic base 11, through a through hole 8, the inside surface of which is coated with a conductor. This ceramic base 11 is covered by a ceramic cap 9 so as to form a chip resonator. Such a chip resonator is directly mounted on a printed board and constitutes various electrical circuits by connecting the thick film electrode 7 and the printed pattern of the printed board. A lead terminal which projects under the ceramic base 11 may be provided instead of the thick film electrode 7.

Temperature characteristic of the resonator will be described hereinafter. A resonator should generate resonance of stable frequency irrespective of changes in ambient temperature. The present inventors found that the temperature characteristics of a resonator depend upon the orientation of the crystal and energy trapped within the resonance chip. On the basis of this discovery, they attempted to optimize the temperature characteristics of a resonator by selecting the optimal relationship for the parameters.

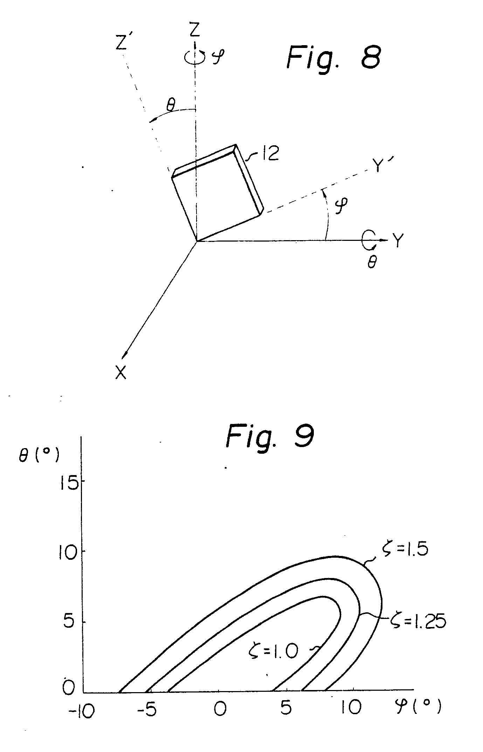

Figure 8 shows an X-cut plate of double rotation, in which the plate is rotated about the Y-axis by angle $\theta$ and about the X-axis by angle $\phi$. The influence of temperature change upon the resonance frequency mainly depends upon the primary temperature coefficient of the resonance chip. If the temperature characteristic of the resonance chip is to be optimal, the primary temperature coefficient thereof should be zero.

Figure 9 is a graphic view of the relationship between the orientation of the crystal and the trapped energy $\zeta$, with respect to the strip shaped resonance chip of the double-rotation X-cut plate which has the primary temperature coefficient of zero. For example, as for the resonance chip of $\zeta=1.5$, the primary temperature coefficient is zero if $\theta$ and $\phi$ satisfy the relationship graphically represented by the graph of $\zeta=1.5$ in Figure 9.

With respect to the strip shaped chip as shown in Fig. 2, the trapped energy $\zeta$ is defined as follows.

$$\zeta=l/H\sqrt{(fa-fe)/fa} \qquad (a)$$

wherein l: length of the electrode
H: thickness of the resonance chip
fe: cut-off frequency at the portion of electrode
fa: cut-off frequency at the portion without electrode

As for the X-cut plate of lithium tantalate, $(fa-fe)/fa=0.1$. Therefore, $\zeta$ depends upon l/H.

When $\theta$ and $\phi$ are to be determined from the graph of Fig. 9, the optional $\theta$ and $\phi$ must be chosen considering the condition of $\zeta$ so that the single mode resonance can be obtained.

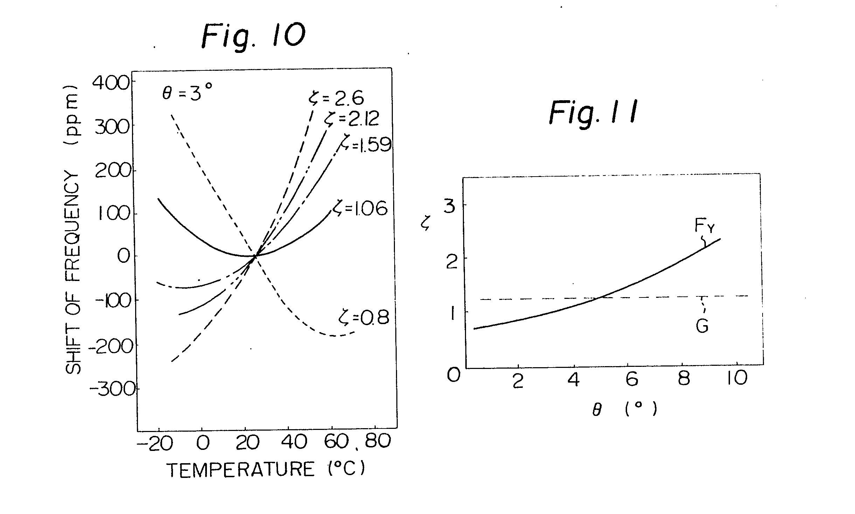

In Fig. 10, the abscissa represents the ambient temperature (°C) and the ordinate represents the shift of resonance frequency (ppm). The shift of resonance frsquency is represented by $\Delta fr/fr$, in which fr is the resonance frequency of the specimen (resonance chip) used in the experiment and $\Delta fr$ is the shifted amount of resonance frequency in response to the change of temperature. Each graph represents the temperature characteristic of different trapped energy $\zeta$. The trapped energy $\zeta$ is changed by changing the length l of the electrode. Five kinds of specimens of $\zeta=2.65, 2.12, 1.59, 1.06,$ and $0.8$ were used in the experiment. The X-cut plate used in the experiment was a 3° Y-X-cut plate rotated about the Y-axis by an angle $\theta$ of 3°. As can be seen from Fig. 10, the temperature characteristic of the specimen of $\zeta=1.06$ is the best shown, since the turning point is about 25°C, which is about normal room temperature, and the change of shift of frequency is minimized at that temperature. The turning point is higher than 25°C when $\zeta$ of the specimen is smaller then 1.06. The turning point is lower when $\zeta$ is increased.

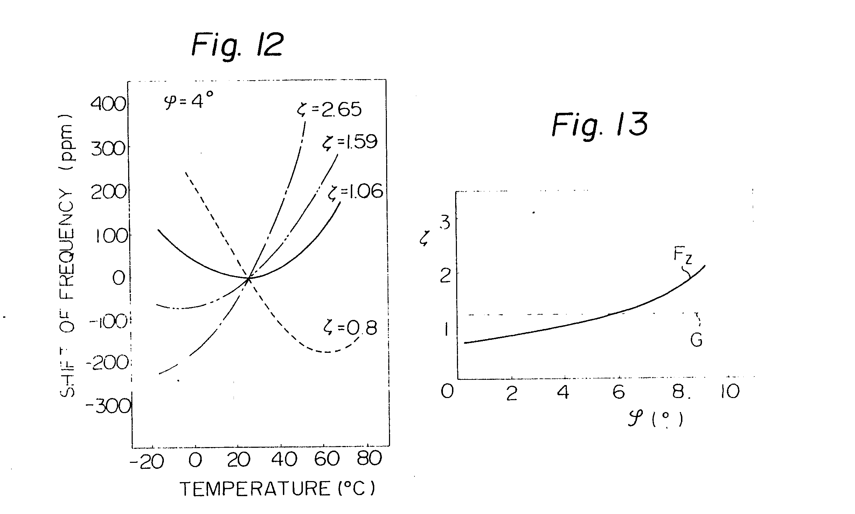

In Fig. 11, the abscissa represents the rotated angle of the resonance chip of X-cut plate of lithium tantalate about the Y-axis of the crystal. The ordinate represents the trapped energy $\zeta$. Graph $F_Y$ represents the relationship between the angle $\theta$ and the enclosed energy $\zeta$, in which relationship the turning point of the temperature characteristic of the resonance chip is about normal room temperture (23°C). The dotted line G represents the maximum value of the trapped energy $\zeta$ required for the single mode resonance of the strip shaped chip of lithium tantalate, experimentally examined at 3.6 MHz.

The curve $F_Y$ of Figure 11 can be represented by a formula

$$\zeta=\frac{1}{8}\cdot\theta+0.65$$

in the region where the enclosed energy $\zeta$ is less than 1.25 at room temperature. If the ambient temperature of the resonance chip is within the range of the normal room temperature $\pm5°C$, then graph $F_Y$ can be represented by the formula

$$\zeta = \frac{1}{8} \cdot \theta + (0.65 \pm 0.1).$$

Figure 12 is a graphic view of the temperature characteristic with respect to various trapped energy $\zeta$, in the case of $\theta = 0°$ and $\varphi = 4°$. The graph of $\zeta = 1.06$ is the most desirable since the turning point is about normal room temperature and the variation of frequency with respect to the change of the temperature is minimized. Graph $F_z$ in Fig. 13 represents the relationship between $\zeta$ and $\varphi$ for obtaining the temperature characteristic in which the apex temperature is equal to normal room temperature. The condition is single mode oscillation of the resonance chip of normal frequency is $\zeta < 1.25$. Therefore, $l/H < 3.95$ is derived from the aforementioned formula (a). Graph $F_z$ is below G when $\varphi$ is less than about 6°, i.e., the rotational angle about the Z-axis is within the range of −6° to 6°. The graphs of Fig. 9 can be applied to $\theta$ of below zero by symmetrically rotating the graphs with respect to the point $\theta = 0$ and $\varphi = 0$.

These graphs in view of the condition of $\zeta$ for obtaining the single mode resonance shows that each of $\theta$ and $\varphi$ should be within ±10.°

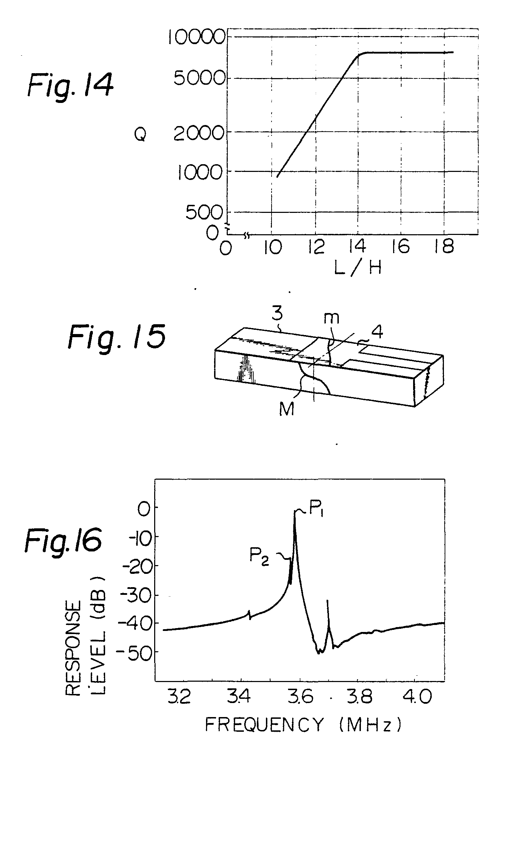

Figure 14 is a graphic view of experimental results of the quality factor Q with respect to L/H, in which L is the length and H is the thickness of the resonance chip of lithium tantalate of Fig. 2. In Fig. 14, the abscissa represents L/H and the ordinate represents Q. The graph represents the relationship between Q and L/H. Q is constant in the region of L/H>14 but falls in the region of L/H<14. Therefore, it is desirable that L/H be larger than 14 so as to obtain resonance chips of stable and high quality.

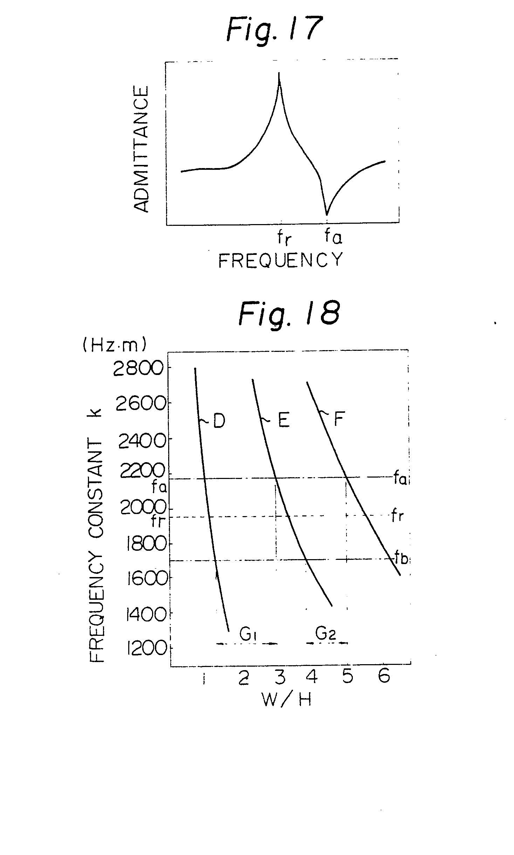

Figure 15 is a perspective view of the resonance chip of lithium tantalate of Fig. 2 for explaining the oscillation modes of the resonance chip. Figure 16 is a graphic view of the frequency characteristic of the resonance chip. Figure 17 is a graphic view of the admittance characteristic of the resonance chip.

As illustrated in Fig. 15, when a prescribed electric field is applied between the upper electrode 4 and the lower electrode (not shown) of the resonance chip 3, thickness shear, oscillation mode M which is used as primary oscillation of the resonance chip, and width shear mode m, which affects the frequency characteristic, are generated. The frequency of the resonance mode m depends upon the width W of the resonance chip 3 and decreases as the width W increases.

In Fig. 16, the abscissa represents frequency (MHz) and the ordinate represents response level (dB). The graph represents the frequency characteristic of the resonance chip. The peak $P_1$ of the graph corresponds to the resonance of the thickness shear mode M. The peak $P_2$ is a spurious response which is generated when the width shear mode m interferes the thickness shear mode M. If the frequency of this spurious response is near that of thet peak $P_1$, the characteristic of the resonance chip is degraded.

In Fig. 17, the abscissa represents the frequency f and the ordinate represents the admittance. The graph represents the admittance characteristic of the resonance chip. Point fr on the abscissa designates the frequency of the resonance and point fa designates the frequency of the antiresonance. The frequency of the resonance of the resonance chip is unstable if the spurious response is generated near the frequency point of fr. Therefore, the spurious responses must be sufficiently away from the point fr.

Figure 18 is a graphic view of experimental results of the constant k (Hz · m) of frequency in which spurious response is generated due to the width shear mode, with respect to the ratio W/H.

In Fig. 18, the abscissa represents W/H and the ordinate represents k. Graphs D, E, and F represent the relationship between k and W/H with respect to the first, third, and fifth width shear mode, repectively, in which spurious responses are generated. The dotted line fr represents k of resonance. The dash-dot line fa represents antiresonance. The dash-two dot line represents the minimum k for avoiding adverse influence from the spurious response. As can be seen from Fig. 18, a first region $G_1$ of W/H between about 1.35 and 3, and a second region $G_2$ of W/H between about 3.8 and 5 are free from adverse influences of spurious response.

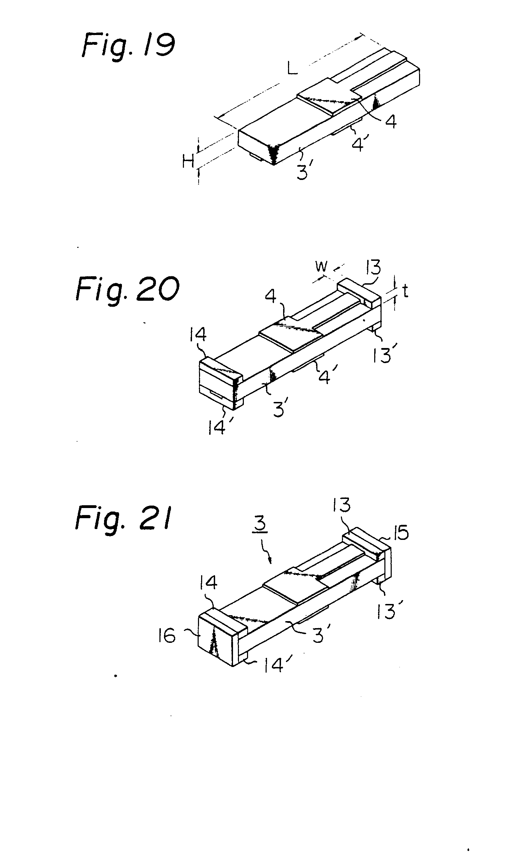

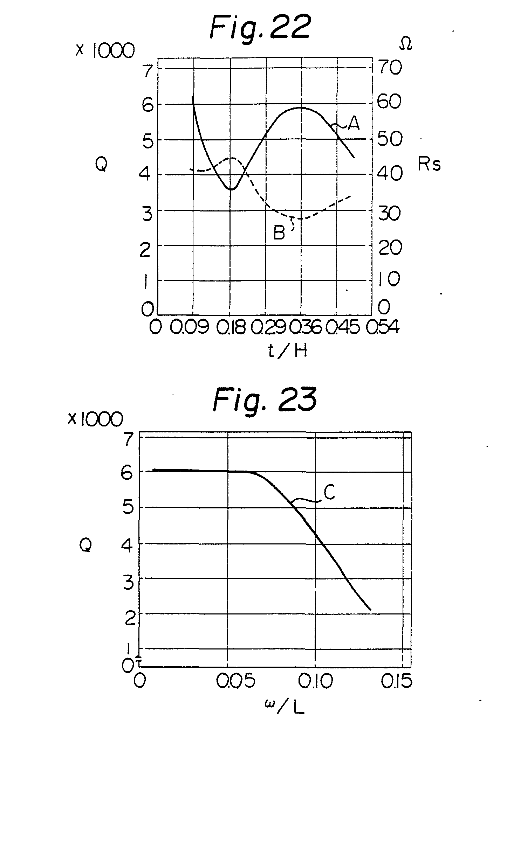

Figure 19 to 21 are views for explaining the construction of the resonance chip embodying the present invention. Figure 22 is a graphic view of experimental results of the quality factor Q and the equivalence series resistance $R_s$ with respect to the thickness ratio t/H.

Figure 23 is a graphic view of another experimental result of the quality factor Q with respect to width ratio w/L.

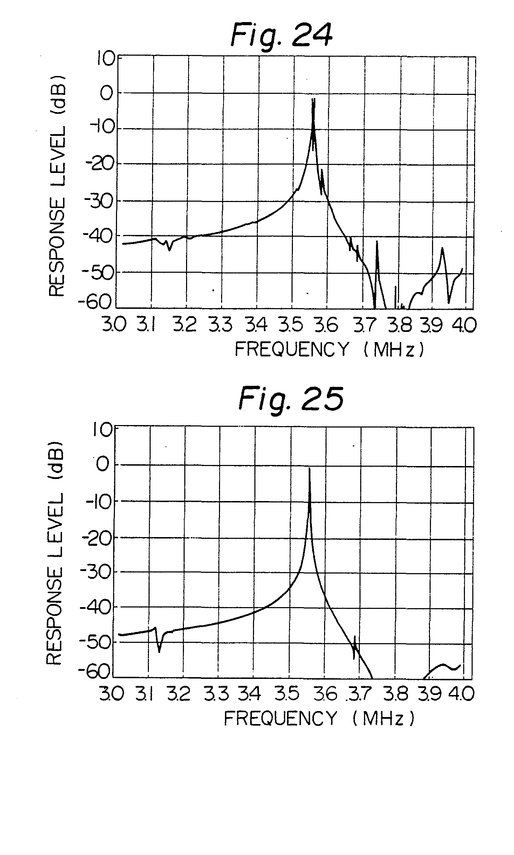

Figure 24 is a graphic view of the frequency characteristics of the resonance chip in which the thickness ratio t/H is 0.1. Figure 25 is a graphic view of the frequency characteristic of the resonance chip in which the thickness ratio t/H is 0.36.

In Fig. 19, a strip shaped resonance chip plate 3' of lithium tantalate which has a rectangular cross-section is illustrated. The length and the thickness of the resonance chip plate 3' are represented by L and H, respectively. T shaped electrode patterns 4 and 4' are formed by an evaporation method on the upper and lower surfaces of the resonance chip plate 3'.

After that, as illustrated in Fig. 20, two pairs of terminal conductors 13, 13' and 14, 14' are formed on both ends of the resonance chip plate 3' by a printing method. The terminal conductor 13 is superposed on the end of the electrode 4. The terminal conductor 14' is superposed on the end of the electrode 4'.

After that, each pair of terminal conductors 13, 13' and 14, 14' is connected by a connecting conductor 15 or 16, so as to form a resonance chip 3, as illustrated in Fig. 21.

The terminal conductors 13, 13', 14, 14' are printed by using conductive paste such as silver paste. The thickness t and the width w of each terminal conductor are determined on the basis of experimental results, described later, so that the thickness ratio t/H is about 0.27 to 0.43 and the width ratio w/L is smaller than 0.06. The resonance chip 3 is mounted on a base (not shown) of a resonator package (not shown). A lead wire of the resonator package is connected to each of the electrode 4, 4' through the terminal conductors 13, 14' and the connecting conductors 15, 16. The connection between the lead wire and the connecting conductors 15, 16 is achieved simultaneously with the forming process of the connecting conductors 15, 16 by the printing method. Assembly of the resonator package is completed by covering the base by a cap (not shown).

In Fig. 22, the abscissa represents the thickness ratio t/H of the terminal conductor. The ordinate of the left represents the quality factor Q. The ordinate of the right represents the equivalence series resistance $R_s$. Graphs A and B represent the relationship between t/H and Q and the relationship between t/H and $R_s$, respectively. Both graphs are based on experimental data. The resonance chip of lithium tantalate used in the experiment has a length L of 8 mm, a width W of 1.6 mm, a thickness h of 0.55 mm, and a width ratio w/L of 0.05. In Fig. 22, as can be seen from graph A of the characteristic of Q, the value of Q is minimized when the thickness ratio t/H is 0.18, in which the value of Q is about 3,750. The desirable value of Q is larger than 5,000. Therefore, the thickness ratio t/H should be less than 0.11 or between 0.27 and 0.46. The resonance resistance $R_s$ is maximum (45 Ω) when the thickness ratio t/H is 0.18. The desirable value of $R_s$ is below 30 Ω. Therefore, the thickness ratio t/H should be 0.29 to 0.42. In order to simultaneously satisfy the desirable condition with respect to the quality factor Q and the equivalence series resistance $R_s$, the desirable range of the thickness ratio t/H is between 0.29 and 0.42.

In Fig. 23, the abscissa represents the width ratio w/L and the ordinate represents the quality coefficient Q. Graph C represents experimental results of the relationship between w/L and Q. As can be seen from Fig. 23, the value of Q is constant (about 6,000) when the width ratio w/L is below 0.06 and decreases when the width ratio w/L exceeds 0.06. Therefore, the width ratio w/L should be below 0.06 in order to obtain a desirable value of Q.

In Fig. 24, the abscissa represents the frequency (MHz) and the ordinate represents the response level (dB). The graph represents the frequency characteristic of the resonance chip in which the thickness ratio t/H is 0.1, which is out of the aforementioned desirable range, i.e., between 0.29 to 0.42. As can be seen from this graph, spurious response is generated in the critical region of the frequency.

In Fig. 25, the abscissa and the ordinate represent the same parameters as those of Fig. 24. The graph represents the frequency characteristic of the resonance chip in which the thickness ratio t/H is 0.36, which is within the aforementioned desirable range, i.e., between 0.29 and 0.42. Spurious oscillation is eliminated from the critical region of the frequency as was seen in Fig. 24.

As mentioned above, the angle between the longitudinal direction of a resonance chip embodying the present invention and the Y-axis of the crystal is determined to be −50±2°; in this way efficiency of transformation can be increased and spurious response can be reduced, with the result that the quality of the resonator is upgraded.

An optimal temperature characteristic can be obtained without generating spurious response by selecting the trapped enery ζ in view of the angle rotated about each axis of the crystal.

An optimal ratio of the thickness of the resonance chip to the length thereof and an optimal ratio of the width of the resonator chip to the thickness thereof can be determined, so that a resonator of high reliability and high quality in which spurious response is effectively eliminated can be obtained.

Also, an optimal dimension of the terminal conductor formed on each end of the resonance plate can be determined, so that it is possible to obtain a resonator of high reliability and high quality in which spurious response is effectively eliminated.

### Claims

1. A piezoelectric resonator which resonates due to thickness shear, comprising a strip shaped resonance chip, made of an X-cut plate of lithium tantalate crystal and having a rectangular cross-section, and electrodes, formed at the centre portion with respect to the longitudinal direction of said resonance chip at the two X-plane surfaces thereof, the width of said electrodes being equal to the width of said resonance chip, characterised in that the longitudinal direction of said resonance chip is inclined with respect to the Y-axis at an angle of −50° ±2° (in the anticlockwise direction) in the X-plane so as to make said longitudinal direction of said resonance chip coincide with the displacement direction of the primary mode of the plate, in that said X-cut plate is rotated about the Y-axis and/or Z-axis within an angle range of 10°, the angles of rotation about the Y-axis and/or Z-axis being selected so that the trapped energy of the oscillation in said resonance chip is such that the primary temperature coefficient of said resonance chip is zero, and in that the ratio I/H is below 3.95, where I is the length of said electrodes and H is the thickness of the resonance chip plate.

2. A piezoelectric resonator as set forth in claim 1, characterised in that a measure for the trapped energy ζ is defined by

$$\zeta = \frac{1}{8} \cdot \theta + (0.65 \pm 0.1)$$

wherein the angle of rotation about the Z-axis is zero and the angle of rotation about the Y-axis is θ degrees.

3. A piezoelectric resonator as set forth in claim 1 or claim 2, characterised in that the angle of rotation about the Y-axis is zero and the angle of rotation about the Z-axis is between −6° and +6°.

4. A piezeoelectric resonator as set forth in any preceding claim, characterised in that ratio L/H is more than 14 and the ratio W/H is between 1.35 and 3.0 or between 3.8 and 5.0, where L, W, and H are respectively the length, width and thickness of the resonance chip.

5. A piezoelectric resonator as set forth in any preceding claim, characterised in that a pair of terminal conductors is formed in the opposite X-plane surfaces of each end of said resonance chip for connecting with wiring outside of the resonator, the thickness t and width w of each said terminal conductor and the length L and thickness H of said resonance chip being such that the ratio t/H is between 0.29 and 0.42, and the ratio w/L is less than 0.06.

**Patentansprüche**

1. Piezoelektrischer Resonator, welcher aufgrund von Dickenscherung schwingt, it einem streifenförmigen Resonanzchip, das aus einer X-geschnittenen Platte aus Lithiumtantalatkristall hergestellt ist und einen rechtwinkligen Querschnitt und Elektroden hat, die im zentralen Abschnitt im Bezug auf die Längsrichtung des genannten Responanzchip und den beiden X-Ebenen-Oberflächen desselben gebildet sind, wobei die Breite der genannten Elektroden gleich der Breite des genannten Resonanzchip ist, dadurch gekennzeichnet, daß die Längsrichtung des genannten Resonanzchip in Bezug auf die Y-Achse um einen Winkel von −50° ±2° (gegen den Uhrzeigersinn) in der X-Ebene geneigt ist, um so die genannte Längsrichtung des genannten Resonanzchips mit der Versetzungsrichtung des Primärmodus der Platte koinzidieren zu machen, daß die genannte X-geschnittene Platte um die Y-Achse und/oder Z-Achse innerhalb eines Winkelbereiches von 10° rotiert ist, wobei die Winkel der Rotation un die Y-Achse und/oder Z-Achse so ausgewählt sind, daß die in dem genannten Resonanzchip eingefangene Oszillationsenergie derart ist, daß der primäre Temperaturkoeffizient des genannten Responanzchip null ist und daß das Verhältnis l/H unterhalb 3,95 ist, wobei l die Länge der genannten Elektroden und H die Dicke der Resonanzchipplatte ist.

2. Piezoelektrischer Resonator nach Anspruch 1, duadurch gekennzeichnet, daß ein Maß für die gefangene Energie ζ definiert ist durch

$$\zeta = \frac{1}{8} \cdot \theta + (0{,}65 \pm 0{,}1),$$

wobei der Rotationswinkel un die Z-Achse null und der Rotationswinkel un die Y-Achse Grad ist.

3. Piezoelektrischer Resonator nach Anspruch 1 oder 2, dadurch gekennzeichnet, daß der Rotationswinkel um die Y-Achse null ist und der Rotationswinkel um die Z-Achse zwischen −6° und +6° ist.

4. Piezoelektrischer Resonator nach einem der vorhergehenden Ansprüche, dadurch gekennzeichnet, daß das Verhältnis L/H größer als 14 und das Verhältnis W/H zwischen 1,35 und 3,0 oder zwischen 3,8 und 5,0 ist, wobei L, W und H die Länge, Breite bzw. Dicke des Resonanzchip sind.

5. Piezoelektrischer Resonator nach einem der vorhergehenden Ansprüche, dadurch gekennzeichnet, daß ein Paar von Anschlußleitern an den gengenüberliegenden X-Ebenen-Oberflächen von jedem Ende des genannten Resonanzchip gebildet ist, zur Verbindung mit der Verdrahtung außerhalb des Resonators, die Dicke t und die Breite w von jedem Anschlußleiter und die Länge L und die Dicke H von dem Resonanzchip so sind, daß das Verhältnis t/H zwischen 0,29 und 0,42 und das Verhältnis w/L kleiner als 0,06 ist.

**Revendications**

1. Résonateur piézo-électrique qui résonne en raison d'un cisaillement en épaisseur, comprenant une pastille à résonance en forme de bande, faite d'une plaque en couple X d'un cristal de tantalate de lithium et ayant une section transversale rectangulaire, et des électrodes formées à la partie centrale par rapport à la direction longitudinale de ladite pastille à résonance à ses deux surfaces de plan X, la largeur desdites électrodes étant égale à la largeur de ladite pastille à résonance, caractérisé en ce que la direction longitudinale de ladite pastille à résonance est inclinée par rapport à l'axe Y d'un angle de −50° ±2° (dans les sens inverse des aiguilles d'une montre) dans le plan X de manière que ladite direction longitudinale de ladite pastille à résonance coïncide avec la direction du déplacement du mode primaire de la plaque, en ce que ladite plaque de couple X est tournée autour de l'axe Y et/ou de l'axe Z dans une plage angulaire de 10°, les angles de rotation autour de l'axe Y et/ou de l'axe Z étant choisis de manière que l'énergie piégée de l'oscillation dans ladite pastille à résonance soit telle que le coefficient de température primaire de ladite pastille à résonance soit nul et en ce que le rapport l/H soit inférieur à 3,95, où l est la longueur desdites électrodes et H est l'épaisseur de ladite plaque de pastille à résonance.

2. Résonateur piézo-électrique selon la revendication 1, caractérisé, en ce qu'une mesure de l'énergie piégée ζ est définie par

$$\zeta = \frac{1}{8} \cdot \theta + (0{,}65 \pm 0{,}1)$$

où l'angle de rotation autour de l'axe Z est nul et l'angle de rotation autour de l'axe Y est θ degrés.

3. Résonateur piézo-électrique selon la revendication 1 ou la revendication 2, caractérisé en ce que l'angle de rotation autour de l'axe Y est nul et que l'angle de rotation autour de l'axe Z est comprise entre −6° et +6°.

4. Résonateur piézo-électrique selon l'une quelconque des revendications précédentes, caractérisé en ce que le rapport L/H est supérieur à 14 et le rapport W/H est compris entre 1,35 et 3,0 ou entre 3,8 et 5,0, où L, W et H sont respectivement la longueur, la largeur et l'épaisseur de la pastille à résonance.

5. Résonateur piézo-électrique selon l'une quelconque des revendications précédentes, caractérisé en ce qu'une paire de conducteurs terminaux est formée dans les surfaces opposées dans le plan X de chaque extrémité de la pastille à résonance pour la connexion avec un cablage extérieur au résonateur, l'épaisseur t et la largeur w de chacun desdites conducteurs terminaux et la longueur L et l'épaisseur H de ladite pastille à résonance étant telle que le rapport t/H soit compris entre 0,29 et 0,42 et que le rapport w/L soit inférieur à 0,06.

Fig. 1

Fig. 2

Fig. 3

1

# Fig. 4

# Fig. 5

## Fig. 6

## Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

## Fig. 22

## Fig. 23

## Fig. 24

## Fig. 25